# EUROPÄISCHE PATENTSCHRIFT

(11) **EP 4 177 617 B1**
(45) Veröffentlichungstag und Bekanntmachung des Hinweises auf die Patenterteilung: **01.07.2026**
(21) Anmeldenummer: 22205075.9
(22) Anmeldetag: 02.11.2022
(51) Int. Cl.: G01R 23/07, G01R 23/163, G01R 31/28, G01R 33/00, G01R 33/032, G01R 33/26, G01N 24/00

(54) **VERFAHREN, VORRICHTUNG UND SOFTWARE ZUR BESTIMMUNG EINER RESONANZFREQUENZ EINES QUANTENSYSTEMS**
METHOD, DEVICE AND SOFTWARE FOR DETERMINING A RESONANT FREQUENCY OF A QUANTUM SYSTEM
PROCÉDÉ, DISPOSITIF ET LOGICIEL POUR LA DÉTERMINATION D'UNE FRÉQUENCE DE RÉSONANCE D'UN SYSTÈME QUANTIQUE

(30) Priorität: 04.11.2021 DE 102021212449
(43) Veröffentlichungstag der Anmeldung: 10.05.2023
(73) Patentinhaber: Universität Stuttgart, Körperschaft des öffentlichen Rechts, 70174 Stuttgart (DE)
(72) Erfinder: NIETHAMMER, Matthias, 70469 Stuttgart (DE)
(74) Vertreter: FDST Patentanwälte

(56) Entgegenhaltungen:
- DE-A1- 102019 211 694
- US-A1- 2019 097 579
- VAN DIJK JEROEN P G ET AL: "Designing a DDS-Based SoC for High-Fidelity Multi-Qubit Control", IEEE TRANSACTIONS ON CIRCUITS AND SYSTEMS I: REGULAR PAPERS, IEEE, US, vol. 67, no. 12, 1 December 2020 (2020-12-01), pages 5380 - 5393, XP011823596, ISSN: 1549-8328, [retrieved on 20201201], DOI: 10.1109/TCSI.2020.3019413

## Beschreibung

Die Erfindung betrifft ein Verfahren zur Bestimmung einer Resonanzfrequenz eines Quantensystems in einem Frequenzbereich. Die Erfindung betrifft weiterhin eine Vorrichtung zur Durchführung des Verfahrens, und eine Software auf einem Datenträger.

Unter einem Quantensystem ist hier und im Folgenden insbesondere ein physikalisches System mit mindestens zwei Quantenzuständen zu verstehen, wobei Übergänge zwischen Quantenzuständen durch jeweils eine Resonanzbedingung oder Resonanzfrequenz charakterisierbar sind. Zu solchen Quantensystemen gehören, ohne darauf beschränkt zu sein, auch sogenannte Spin-Verunreinigungen oder Spin-Defekte in Feststoffen. Insbesondere Farbzentren in Diamanten, wie beispielsweise das negativ geladene Stickstofffehlstellen-Zentrum (engl. Nitrogen Vacancy Center, NV), haben sich als vielseitige Quantensysteme mit einer Vielzahl von Anwendungen in der Quantenoptik, der Informationsverarbeitung und der Quantensensorik erwiesen.

Für die praktische Anwendung von Quantensystemen, beispielsweise als Quantensensor oder als Quantenbit (Qubit), ist es notwendig, die Arbeitspunkte des Quantensystems zu bestimmen, damit ein Kontrollsystem den Quantenzustand des Quantensystems korrekt manipulieren kann. Unter einem Arbeitspunkt des Quantensystems ist hierbei zumeist eine Resonanzbedingung zu verstehen, welche durch Veränderung einer Frequenz oder eines anderen Parameters einen Übergang oder Änderung des Quantenzustands verursacht.

Initial ist die Resonanzbedingung in Form einer Resonanzfrequenz, insbesondere bei Sensorikanwendungen, unbekannt. Daher ist es notwendig, einen großen Frequenzbereich abzusuchen, um die Resonanzfrequenzen des Quantensystems zu bestimmen. Die dafür benötigte Zeitdauer steigt mit der (Frequenz-)Breite des abzusuchenden Frequenzbereichs stark an, wodurch eine praktische Anwendung der Quantensensorik erschwert wird. Insbesondere ist es hierbei notwendig, dass die Umgebungsbedingungen (und teils auch das interne Quantensystem) innerhalb dieser Zeitspanne konstant bleiben, um eine eindeutige Bestimmung der Resonanzfrequenz, und somit der gewünschten Kontrollparameter, zu erreichen.

Typischerweise werden hierbei lineare Frequenzsweeps verwendet, bei welchen der Frequenzbereich sukzessive mit aufeinanderfolgenden Messfrequenzen abgetastet wird, wobei parallel hierzu ein vom Quantensystem resultierendes Messsignal erfasst wird. Zur Verbesserung eines Signal-zu-Rausch-Verhältnis des Messsignals werden häufig spezielle Detektionsmethoden wie zum Beispiel eine balancierte Detektion oder phasensensitive Lock-In-Verstärker verwendet. Jedoch ist hierbei stets eine minimale Messdauer pro Frequenzpunkt nötig.

Insbesondere bei Unkenntnis über die grobe Resonanzbedingung, zum Beispiel aufgrund von unbekannten, zu messenden Magnetfeldern, ist es in der Quantensensorik häufig notwendig, sehr breite Frequenzbereiche abzusuchen, um die gewünschte Resonanzfrequenz zu erhalten. Erst in Kenntnis der Resonanzfrequenz können Locking- oder Tracking-Verfahren für den weiteren Qubit-Manipulations- oder Sensingprozess verwendet werden.

Nachteilig bei solchen Frequenzsweeps ist insbesondere die aufgewendete Messzeit pro Frequenzpunkt, welche für jeden Frequenzpunkt, auch abseits der Resonanzbedingung, verwendet wird. Dadurch wird ein Großteil der Messdauer auf Messpunkte investiert, welche keine relevante Information aufweisen. Ein kompletter Frequenzsweep des Frequenzbereichs kann hierbei mehrere Sekunden dauern. Dies führt zu einer zeitintensiven Arbeitspunktbestimmung für das (Quanten-)Kontrollsystem. Ändert sich das Messsignal beziehungsweise die Resonanzbedingung innerhalb dieser Zeitspanne, so ist eine gezielte Anwendung des Quantensystems in der Folge nicht möglich. Die Geschwindigkeit des Frequenzsweeps ist hierbei insbesondere durch eine Sweepgeschwindigkeit der Frequenzquelle limitiert.

Aus van Dijk et al., "Designing a DDS-Based SoC for High-Fidelity Multi-Qubit Control", EEE Transactions on Circuits and Systems I: Regular Papers. PP. 1-14. 10.1109/TCSI.2020.3019413 (2020) ist eine skalierbare elektronische Steuereinrichtung für großskalige Quantencomputer bekannt, welche eine gleichzeitige und hochpräzise Ansteuerung mehrerer Qubits, insbesondere Spin-Qubits oder Transmons, ermöglicht. Auf Basis analytischer und simulationsgestützter Methoden werden detaillierte elektrische Spezifikationen sowie ein vollständiges Fehlerbudget für analoge und digitale Schaltungsblöcke abgeleitet.

Die DE 10 2019 211 694 A1 offenbart ein Verfahren zum Bestimmen eines Resonanzmodells eines diamantbasierten Magnetfeldsensors zum Kalibrieren eines Messsystems zur Magnetfeldmessung. Hierbei wird der Magnetfeldsensormit Messpunkten vermessen, die durch eine Mikrowellenstrahlung mit einer Mikrowellenfrequenz bestimmt sind, um eine zugehörige Fluoreszenzmaß zu ermitteln, wobei das Fluoreszenzmaß das Vorliegen einer Fluoreszenz eines Diamantkristalls des Magnetfeldsensors angibt. Weiterhin wird ein Resonanzmodell als ein Gaußprozessmodell ermittelt, das angibt, in welchen Mikrowellenfrequenzbereichen eine Resonanz auftritt, wobei das Resonanzmodells für eine Messung eines Magnetfelds mit dem Magnetfeldsensors verwendet wird.

In der US 2019/097579 A1 ist ein Verfahren zum Bestimmen charakteristischer Parameter eines elektrostatischen Ansteuerungsoszillators beschreiben. Verfahrensgemäß wird eine erste Erregerspannung, die als Summe einer ersten Sinusspannung und eines Spannungsimpulses definiert ist erzeugt, und an den Eingang eines Oszillators angelegt. Anschließend wird eine erste Antwortspannung, die am Ausgang des Oszillators vorhanden ist, erfasst, wenn die erste Erregungsspannung an den Eingang des Oszillators angelegt wird. Hernach wird eine erste Amplitudenspektraldichte der ersten Antwortspannung durch Transformation in den Frequenzbereich ermittelt, und ein charakteristischer Parameter des Oszillators aus der ersten Amplitudenspektraldichte bestimmt.

Der Erfindung liegt die Aufgabe zugrunde, ein besonders geeignetes Verfahren zur Bestimmung einer Resonanzfrequenz eines Quantensystems in einem Frequenzbereich anzugeben. Insbesondere soll eine möglichst schnelle Bestimmung eines Arbeitspunkts realisiert werden, welche auch für größere Frequenzbereiche hinsichtlich Ressourcen und Zeitbedarf vorteilhaft skaliert. Der Erfindung liegt weiterhin die Aufgabe zugrunde, eine besonders geeignete Vorrichtung sowie eine besonders geeignete Software anzugeben.

Hinsichtlich des Verfahrens wird die Aufgabe mit den Merkmalen des Anspruchs 1 und hinsichtlich der Vorrichtung mit den Merkmalen des Anspruchs 7 sowie hinsichtlich der Software mit den Merkmalen des Anspruchs 8 erfindungsgemäß gelöst. Vorteilhafte Ausgestaltungen und Weiterbildungen sind Gegenstand der Unteransprüche.

Sofern nachfolgend Verfahrensschritte beschrieben werden, ergeben sich vorteilhafte Ausgestaltungen für die Vorrichtung und/oder die Software insbesondere dadurch, dass diese ausgebildet sind, einen oder mehrere dieser Verfahrensschritte auszuführen. Die Konjunktion "und/oder" ist hier und im Folgenden derart zu verstehen, dass die mittels dieser Konjunktion verknüpften Merkmale sowohl gemeinsam als auch als Alternativen zueinander ausgebildet sein können.

Das erfindungsgemäße Verfahren ist zur Bestimmung einer Resonanzfrequenz, also einer Resonanzbedingung oder eines Arbeitspunktes, eines Quantensystems in einem Frequenzbereich vorgesehen, sowie dafür geeignet und eingerichtet. Der Frequenzbereich beziehungsweise die Breite des Frequenzbereichs ist hierbei insbesondere derart gewählt oder vorgegeben, dass sich zumindest eine Resonanzfrequenz innerhalb des Frequenzbereichs befindet. Das Quantensystem ist hierbei beispielsweise ein Quantensensor oder ein Qubit.

Verfahrensgemäß wird der Frequenzbereich in einem ersten Verfahrensschritt in eine Anzahl von vorzugsweise gleich großen Frequenzbins unterteilt. Der Frequenzbereich kann beispielsweise in linearer Abfolge oder vorzugsweise in einem Pseudo-Random-Verfahren in Gruppen beziehungsweise Frequenzbins eingeteilt werden.

Unter einem Frequenzbin ist hierbei insbesondere ein Frequenzteilbereich des Frequenzbereichs zu verstehen, also ein Abschnitt oder ein Intervall auf der Frequenzachse zwischen einem unteren und einem oberen Frequenzwert. Die Frequenzbins sind hierbei vorzugsweise überlappungsfrei, dies bedeutet, dass sich die Bereiche zweier benachbarter Frequenzbins nicht überschneiden. Unter einer "Anzahl von Frequenzbins" sind hierbei insbesondere mehrere Frequenzbins, also mindestens zwei Frequenzbins, zu verstehen. Die Anzahl ist hierbei beispielsweise abhängig von der Breite des Frequenzbereichs oder einer gewünschten Verfahrensdauer. Eine geringe Anzahl von Frequenzbins entspricht einer groben Unterteilung des Frequenzbereichs, welche die Verfahrensdauer auf Kosten der (spektralen) Genauigkeit reduziert, wobei eine hohe Anzahl an Frequenzbins entsprechend in einer feinen Unterteilung des Frequenzbereichs für eine hohe Genauigkeit mit langsamerer Verfahrensdauer resultiert. Die Breite eines Frequenzbins ist hierbei vorzugsweise größer als die (zu erwartende) Linienbreite der Resonanzfrequenz, und umfasst mehrere unterschiedliche Frequenzwerte.

In einem zweiten Verfahrensschritt wird für ein Frequenzbin eine Messfrequenz erzeugt, welche signalverarbeitungstechnisch zu einer das Frequenzbin abdeckenden Frequenzgruppe aufgeweitet wird. Das Quantensystem wird mit dieser Frequenzgruppe manipuliert, wobei ein resultierendes Messsignal erfasst, und mit einem hinterlegten Schwellwert verglichen wird. Dieser Vorgang wird vorzugsweise für jedes Frequenzbin wiederholt.

Die Messfrequenz weist hierbei einen Frequenzwert auf, welcher innerhalb des jeweiligen Frequenzbins liegt. Insbesondere ist die Messfrequenz beispielsweise um einen Frequenzwert in der Mitte des jeweiligen Frequenzbins zentriert. Hierbei wird beispielsweise ein Anregungssignal mittels einer Frequenzquelle, beispielsweise einem Signalgenerator, insbesondere einer Radiowellen- oder Mikrowellenquelle, erzeugt. Das Anregungssignal oszilliert periodisch mit der jeweiligen Messfrequenz, insbesondere ist das Anregungssignal ein Sinussignal.

Die Messfrequenz beziehungsweise das Anregungssignal wird signalverarbeitungstechnisch zu einer das Frequenzbin abdeckenden Frequenzgruppe aufgeweitet. Mit anderen Worten wird die Bandbreite der Messfrequenz derart erhöht, dass die Bandbreite im Wesentlichen der Breite des Frequenzbins entspricht. Dadurch wird effektiv ein Anregungssignal erzeugt, welches mit mehreren Frequenzen oszilliert. Durch die Frequenzgruppe werden somit eine Anzahl von Frequenzen für die Manipulation des Quantensystems erzeugt. Dadurch wird der Frequenzbereich eines Frequenzbins im Wesentlichen vollständig durch die Frequenzgruppe auf ein Mal abgedeckt.

Die Manipulation des Quantensystems erfolgt hierbei insbesondere durch Einstrahlung einer oszillierenden Strahlung auf das Quantensystem. Hierbei ist beispielsweise ein Kontrollsystem mit einer Antennenstruktur in der Umgebung des Quantensystems vorgesehen, welche bei einer Wechselstromanregung ein elektromagnetisches Feld mit einer entsprechenden Frequenz abstrahlt. Die Antennenstruktur wird hierbei mit einem die Frequenzgruppe aufweisenden Wechselstrom als Anregungssignal angeregt, so dass eine oszillierende Strahlung mit der Frequenzgruppe für die Manipulation des Quantensystems erzeugt wird. Durch die Frequenzgruppe wird das Quantensystem gleichzeitig mit einer Anzahl von unterschiedlichen Frequenzen angeregt, wobei die Antwort oder Reaktion des Quantensystems auf diese Anregung gemessen wird.

Ist ein Arbeitspunkt, also eine Resonanzfrequenz, in der aktuellen Frequenzgruppe beziehungsweise in dem Frequenzbin enthalten, so ändert sich das Messsignal. Das Messsignal wird hierbei mit einem Schwellwert verglichen. Hierbei besteht keine hohe Anforderung an das Signal-zu-Rausch-Verhältnis, wodurch die Messzeit pro Frequenzgruppe vorteilhaft reduziert wird. Der Schwellwert ist hierbei hinsichtlich einer zu erwartenden Messsignaländerung im Resonanzfall dimensioniert. Dies bedeutet, dass in dem Frequenzbin, in welchem ein Messsignal den Schwellwert erreicht oder überschreitet, mit einer hinreichenden Wahrscheinlichkeit eine Resonanzfrequenz liegt. Welche Wahrscheinlichkeit hierbei als hinreichend gilt, und wie groß die Wahrscheinlichkeit konkret ist, ist dabei zunächst nebensächlich. Dies lässt sich beispielsweise aus vergangenen Messdaten oder aus entsprechenden Versuchen oder Erprobungen ermitteln. Für unterschiedliche Quantensysteme, Signal-zu-Rausch-Verhältnisse, Frequenzbin-Breiten, Betriebs- und Umgebungsbedingungen oder Anwendungsszenarien sind unter Umständen unterschiedliche Schwellwerte definiert.

In einem dritten Verfahrensschritt wird die Resonanzfrequenz hierbei anhand derjenigen Messignale bestimmt, welche den Schwellwert erreicht oder überschritten haben. Dadurch ist ein besonders geeignetes Verfahren realisiert. Durch die Unterteilung des abzusuchenden Frequenzbereichs in beispielsweise N Frequenzbins, und der Verwendung von Frequenzgruppen mit M Frequenzen, werden im Wesentlichen lediglich N/M Messpunkte für die Untersuchung des Frequenzbereichs benötigt. Mit anderen Worten suchen mehrere Frequenzen gleichzeitig den Frequenzbereich ab, was eine schnellere Suche der Resonanzfrequenz ermöglicht. Da keine hohen Anforderung an das Signal-zu-Rausch-Verhältnis vorliegen, ist eine kurze Messzeit pro Messpunkt ermöglicht, wodurch die Verfahrensdauer weiter vorteilhaft reduziert wird.

Das erfindungsgemäße Verfahren ermöglicht eine Reduktion des Zeitbedarfs für die Bestimmung der Arbeitspunkte beziehungsweise Resonanzfrequenzen eines Quantensystems. Dies ermöglicht beispielsweise eine schnellere Einsatzbereitschaft eines Quantensensors in einer unbekannten Umgebung. Dadurch wird beispielsweise ein Einsatz des Quantensystems in einer wenig kontrollierten Umgebung mit mehr Umgebungsrauschen ermöglicht.

Die Messsignale, bei welchem der Schwellwert erreicht oder überschritten wird, entsprechen einer Kandidaten-Frequenzgruppe oder Kandidaten für Frequenzbins, in welchen sich die gesuchte Resonanzfrequenz befindet. Um die Resonanzfrequenz mit höherer Genauigkeit zu bestimmen, kann in den resultierenden Kandidaten-Frequenzgruppen nun wieder die relevanten Frequenzen gefunden werden. Dies kann durch iterative Anwendung des Verfahrens innerhalb der Kandidaten erfolgen. Erfindungsgemäß werden hierbei in dem dritten Verfahrensschritt die ersten und zweiten Verfahrensschritte iterativ wiederholt, wobei als Frequenzbereich die jeweils vorangegangenen Frequenzbins verwendet werden, bei welchen die Messsignale den Schwellwert erreicht oder überschritten haben. Dies bedeutet, dass die vorangegangenen Frequenzbins wiederum in eine (neue) Anzahl von Frequenzbins unterteilt werden. Der Vorgang wird beispielsweise solange wiederholt, bis eine vorgegebene Mindestgenauigkeit für die Position oder den Frequenzwert der Resonanzfrequenz erreicht ist.

Erfindungsgemäß werden während des dritten Verfahrensschritts die vorangegangenen Messsignale gewichtet aufaddiert. Mit anderen Worten werden zusätzlich alle zuvor erhaltenen Messungen am Ende gewichtet aufaddiert, und tragen somit zu einem besseren Signal-zu-Rausch-Verhältnis der Gesamtlösung bei. Die Suche kann auch vorzeitig abgebrochen und adaptiv auf bereits identifizierte Kandidaten verfeinert werden, z.B. wenn eine vorgegebene oder vorgebbare Anzahl von Messsignalen, welche den Schwellwert erreicht oder überschritten haben, vorliegt. Insgesamt beschleunigt dies die Suche innerhalb eines gegebenen Frequenzbereichs und verringert insbesondere die Verzögerung der Einsatzbereitschaft des Systems.

Das Verfahren findet somit iterativ die korrekten Resonanzfrequenzen. Das Verfahren benötigt weniger Messzeit pro Messpunkt und präselektiert hierbei Kandidatenfrequenzen. Dadurch geht das Verfahren zügig und schrittweise von einem Frequenzscan der Arbeitspunktbestimmung in einen Festfrequenzbetrieb zur Kontrolle des Quantensystems über.

In einer denkbaren Ausführung wird die Breite der Frequenzbins mit jeder Iteration angepasst. Die Frequenz-Bin-Breite kann mit Fortschreiten der Suche angepasst werden, um breiter und somit schneller zu suchen, oder um schmaler und genauer die Arbeitspunkte zu finden.

Ein zusätzlicher oder weiterer Aspekt der Erfindung sieht vor, dass die Messfrequenzen durch ein Frequenz-Spreiz-Verfahren in die jeweiligen Frequenzgruppen aufgeweitet werden. Dies bedeutet, dass Frequenz-Spreizungsverfahren verwendet werden, um eine größere Bandbreite pro Frequenzbin bei der Suche abzutasten. Für die Frequenzspreizung der Messfrequenzen kann beispielsweise ein Frequency-Hopping-Spread-Spectrum-Verfahren (FHSS-Verfahren) verwendet werden.

In einer geeigneten Weiterbildung wird ein auf Modulationstechniken basierendes Frequenz-Spreiz-Verfahren verwendet, dessen Modulation zeitlich variiert. Diese Modulation wird mit dem Messsignal korreliert, wodurch die Arbeitsbedingung beziehungsweise Resonanzfrequenz genauer bestimmt werden kann. Beispielsweise kann bei digitalen Modulationsverfahren, wie zum Beispiel Direct-Sequence-Spread-Spectrum-Verfahren, das aus einem digitalen Spreizcode und einem Nachrichtencode resultierende Frequenzspektrum mit dem (beispielsweise analogen) Messsignal korreliert werden. Dies ermöglicht einen Zugang zu Arbeitspunkten oder Resonanzfrequenzen über breite Frequenzbereiche. Das Verfahren verwendet somit analoge oder digitale Modulationsverfahren und zeitliche Korrelation mit diesen und dem aufgezeichneten Signal, um Rückschlüsse auf die relevanten Arbeitspunkte zu finden.

In einer geeigneten Weiterbildungsform wählt der Nachrichtencode mit dem Spreizcode zusammen die im Signal enthaltenen Frequenzkomponenten aus. Hierbei kann ein randomisierter Nachrichtencode verwendet werden, welcher - solange bekannt - zusammen mit dem Spreizcode die Frequenzbestandteile festlegt und somit eine zeitliche Korrelation und Rückrechnung der Resonanzen ermöglicht. Sobald hierbei aussichtsreichere Frequenzen gefunden wurden, kann z.B. der Nachrichtencode so vorteilhaft angepasst werden, dass diese Frequenzen-Komponenten bevorzugt im gespreizten Signal enthalten sind.

Zusätzliche Vorteile ergeben sich insbesondere hinsichtlich von Kostenaspekten, da ein Technologietransfer aus der modernen Kommunikationstechnik in die Quantenkontrolltechnologie ermöglicht wird. Die hierfür benötigten Bauteile sind auf Grund der Massenverfügbarkeit preisgünstiger als existierende Lösungen.

In einer möglichen Anwendung ist das Quantensystem ein Stickstofffehlstellen-Zentrum in einem Diamanten. Im einfach negativ geladenen Zustand weist ein solches Stickstofffehlstellen-Zentrum ein Spin-1 Elektronenspinmoment mit einem Grundzustand mit einer Nullfeldaufspaltung (engl.: Zero Field Splitting, ZFS) von 2.87 GHz (Gigahertz) zwischen einem nicht-magnetischen Zustand ("0") und den dazugehörigen magnetischen Zuständen ("+1", "-1") auf, sodass eine einfache Manipulation des Elektronenspinmoments mittels Einstrahlung von Hochfrequenzpulsen im Mikrowellenbereich ermöglicht ist.

Bei einer Beleuchtung oder Bestrahlung mit einem grünen mit (Laser-)Licht wird das Elektronenspinmoment des Stickstofffehlstellen-Zentrum einerseits im Wesentlichen vollständig in den nicht-magnetischen Grundzustand ("0") polarisiert. Andererseits emittiert das Stickstofffehlstellen -Zentrum bei einer Anregung Licht im roten Wellenlängenbereich, wobei die Anzahl der Photonen abhängig vom Spinzustand des Elektronenspinmoments vor der Bestrahlung ist. Mit anderen Worten ist der Zustand des Elektronenspinmoments des Stickstofffehlstellen - Zentrums durch Erfassung der emittierten Photonen optisch auslesbar, sodass eine besonders einfache Detektion des Spinzustands möglich ist.

Die erfindungsgemäße Vorrichtung ist zur Bestimmung einer Resonanzfrequenz eines Quantensystems in einem Frequenzbereich vorgesehen, sowie dafür geeignet und eingerichtet. Die im Hinblick auf das Verfahren angeführten Vorteile und Ausgestaltungen sind sinngemäß auch auf die Vorrichtung übertragbar und umgekehrt.

Die Vorrichtung weist hierbei einen Signalgenerator zur Erzeugung einer Messfrequenz, und eine Aufweitungseinheit zur signaltechnischen Aufweitung oder Spreizung der Messfrequenz in eine Frequenzgruppe auf. Die Vorrichtung weist weiterhin ein Kontrollsystem zur Manipulation des Quantensystems und eine Messeinheit zur Erfassung eines Messsignals auf. Die Vorrichtung umfasst einen Controller (das heißt eine Steuereinheit), welcher mit dem Signalgenerator, der Aufweitungseinheit, dem Kontrollsystem und der Messeinheit gekoppelt ist.

Der Controller ist hierbei allgemein - programm- und/oder schaltungstechnisch - zur Durchführung des vorstehend beschriebenen erfindungsgemäßen Verfahrens eingerichtet. Der Controller ist somit konkret dazu eingerichtet, den Frequenzbereich in eine Anzahl von Frequenzbins zu unterteilen, und entsprechende Steuer- oder Regelsignale an den Signalgenerator und/oder die Aufweitungseinheit und/oder das Kontrollsystem zu senden, sowie die Messsignale der Messeinheit auszuwerten.

In einer bevorzugten Ausgestaltungsform ist der Controller zumindest im Kern durch einen Mikrocontroller mit einem Prozessor und einem Datenspeicher gebildet, in dem die Funktionalität zur Durchführung des erfindungsgemäßen Verfahrens in Form einer Betriebssoftware (Firmware) programmtechnisch implementiert ist, so dass das Verfahren - gegebenenfalls in Interaktion mit einem Vorrichtungsnutzer - bei Ausführung der Betriebssoftware in dem Mikrocontroller automatisch durchgeführt wird. Der Controller kann im Rahmen der Erfindung alternativ aber auch durch ein nicht-programmierbares elektronisches Bauteil, wie zum Beispiel einem anwendungsspezifischen integrierten Schaltkreis (ASIC) oder durch einem FPGA (Field Programmable Gate Array), gebildet sein, in dem die Funktionalität zur Durchführung des erfindungsgemäßen Verfahrens mit schaltungstechnischen Mitteln implementiert ist.

Ein zusätzlicher oder weiterer Aspekt der Erfindung sieht eine Software auf einem Medium oder Datenträger zur Durchführung oder Ausführung des vorstehend beschriebenen Verfahrens vor, wenn die Software auf einem Computer abläuft. Dies bedeutet, dass die Software auf einem Datenträger hinterlegt ist, und zur Ausführung des vorstehend beschriebenen Verfahrens vorgesehen, sowie dafür geeignet und ausgestaltet ist. Dadurch ist eine besonders geeignete Software für das Auffinden von Resonanzfrequenzen eines Quantensystems in einem Frequenzbereich realisiert, mit welcher die Funktionalität zur Durchführung des erfindungsgemäßen Verfahrens programmtechnisch implementiert wird. Die Software ist somit insbesondere eine Betriebssoftware (Firmware), wobei der Datenträger beispielsweise ein Datenspeicher eines Controllers ist. Dabei gelten die Ausführungen im Zusammenhang mit dem Verfahren und/oder mit der Vorrichtung sinngemäß auch für die Software und umgekehrt.

Nachfolgend sind Ausführungsbeispiele der Erfindung anhand einer Zeichnung näher erläutert. Darin zeigen in schematischen und vereinfachten Darstellungen:
- Fig. 1: eine Vorrichtung zur Bestimmung einer Resonanzfrequenz eines Quantensystems,
- Fig. 2: in einem Flussdiagramm ein Verfahren zur Bestimmung der Resonanzfrequenz,
- Fig. 3: eine Veranschaulichung eines ersten Verfahrensschritts des Verfahrens, und
- Fig. 4: eine Veranschaulichung eines zweiten Verfahrensschritts des Verfahrens.

Einander entsprechende Teile und Größen sind in allen Figuren stets mit den gleichen Bezugszeichen versehen.

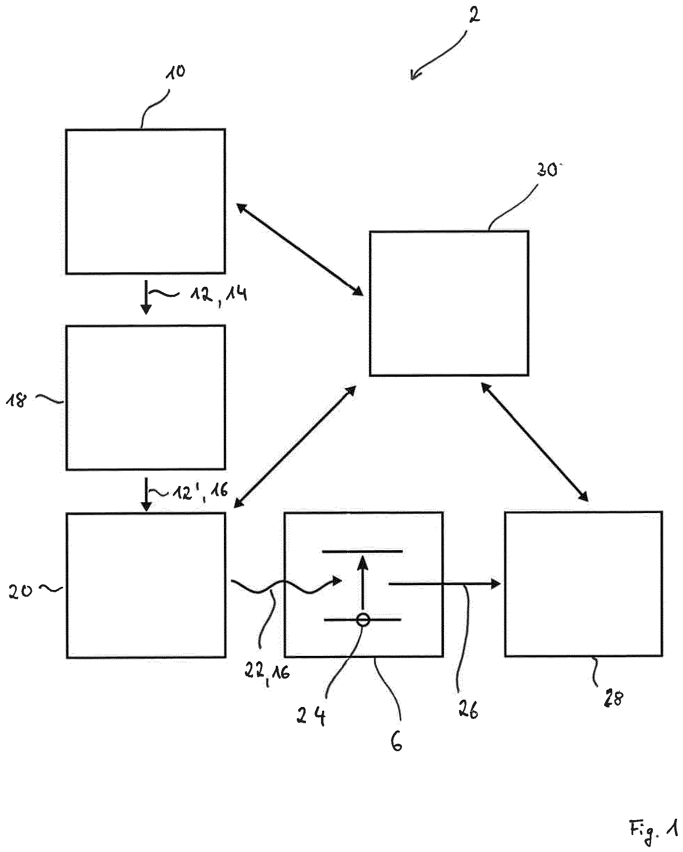

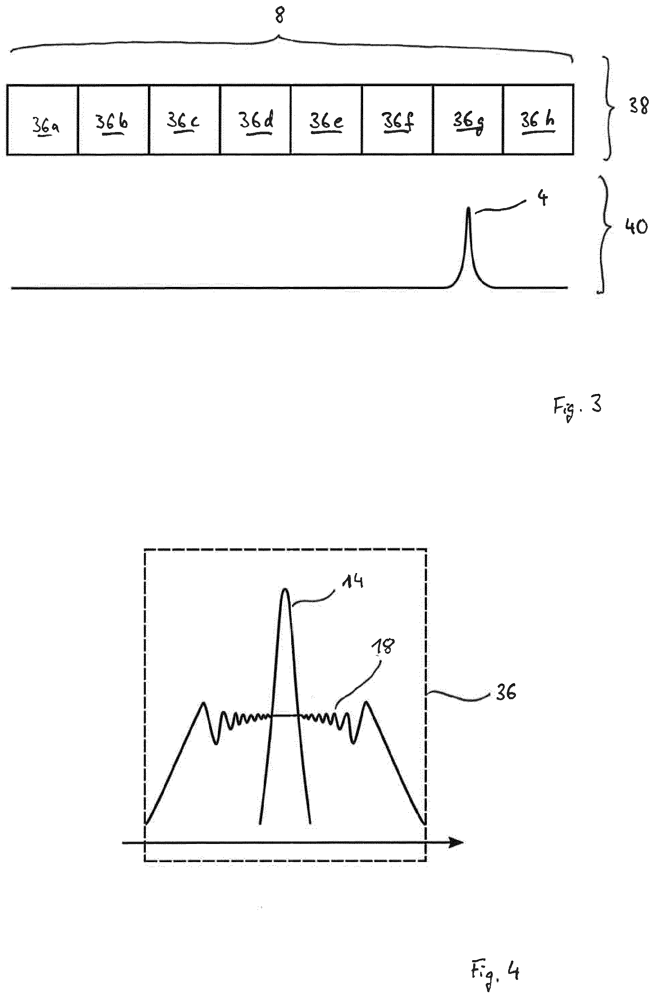

Die Fig. 1 zeigt in schematischer und vereinfachter Darstellung eine Vorrichtung 2 zur Bestimmung einer Resonanzfrequenz 4 eines Quantensystems 6 in einem Frequenzbereich 8 (Fig. 3).

Die Vorrichtung 2 weist einen Signalgenerator 10 zur Erzeugung eines Anregungssignals 12 auf. Das Anregungssignal 12 ist ein oszillierendes Signal, beispielsweise ein Sinussignal, welches mit einer vorgegebenen oder vorgebbaren Messfrequenz 14 oszilliert.

Das Anregungssignal 12 beziehungsweise die Messfrequenz 14 wird einer Aufweitungseinheit 16 zugeführt, welche die Messfrequenz 14 signaltechnisch zu einer Frequenzgruppe 18 aufweitet oder spreizt. Die Aufweitungseinheit 16 erzeugt somit ein Anregungssignal 12' mit einer vergrößerten Bandbreite. Das Anregungssignal 12' weist somit effektiv mehrere Frequenzen als Frequenzgruppe 18 auf.

Die Vorrichtung 2 weist weiterhin ein Kontrollsystem 20 zur Manipulation des Quantensystems 6 auf. Das Kontrollsystem 20 ist hierbei insbesondere dazu vorgesehen und geeignet das Quantensystem 6 mittels einer Strahlung 22 resonant anzuregen, und somit einen Quantenzustand 24 des Quantensystems 6 zu manipulieren oder zu kontrollieren.

Die Antwort oder Reaktion des Quantensystems 6 auf die Anregung wird als ein Messignal 26 mittels einer Messeinheit 28 erfasst oder detektiert. Zur Auswertung der Messsignale 26 ist ein Controller 30 vorgesehen. Der Signalgenerator 10 und das Kontrollsystem 20 sowie die Messeinheit 28 sind mit dem Controller 30 als Steuereinheit gekoppelt.

Das Quantensystem 6 ist hierbei beispielsweise ein NV- oder Stickstofffehlstellen-Zentrum in einem Diamanten. Die Signalquelle 10 ist hierbei insbesondere als eine Radiowellen- und/oder Mikrowellenquelle ausgeführt, wobei die Aufweitungseinheit 18 die Messfrequenz 14 beispielsweise zu einer Frequenzgruppe 16 mit bis zu 100 MHz (Megahertz) Bandbreite aufweitet. Das Kontrollsystem 20 weist hierbei beispielsweise einen grünen Laser zur Anregung und Auslesung des Quantenzustands beziehungsweise Elektronenspinmoments 24, und eine Antennenstruktur, beispielsweise in Form eines Mikrowellenleiters oder Waveguides, zur Erzeugung einer Radiowellen- oder Mikrowellenstrahlung 22 auf. Die Antennenstruktur wird hierbei mit dem Anregungssignal 12' angeregt, und erzeugt hierbei die Strahlung 22 zur Manipulation des Quantenzustands 24. Das Messsignal 26 ist hierbei insbesondere die rote Fluoreszenz des Stickstofffehlstellen-Zentrums, wobei die Messeinheit 28 beispielsweise eine Photodiode, insbesondere eine Lawinenphotodiode (engl.: Avalanche Photo Diode, APD), ist.

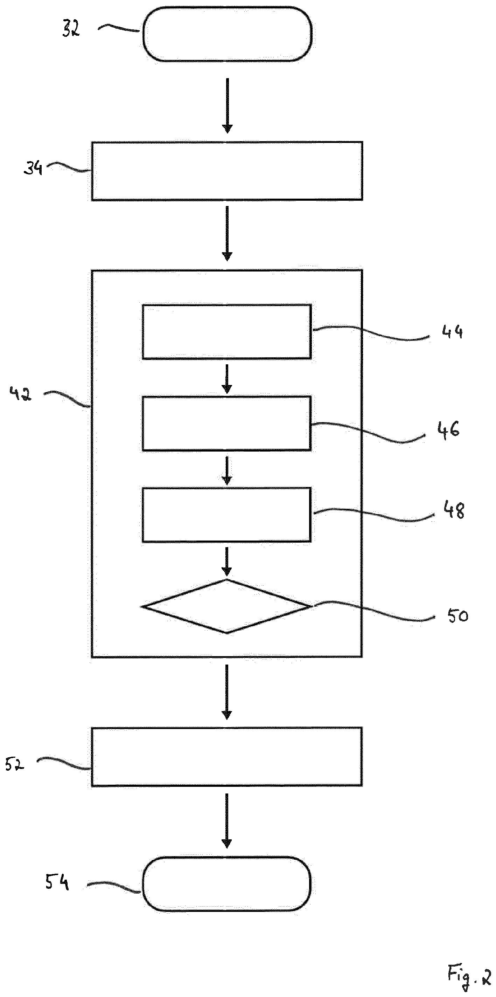

In dem Speicher des Controllers 30 ist eine Software hinterlegt, welche zur Durchführung eines nachfolgend anhand der Figuren 2 bis 4 erläuterten Verfahrens vorgesehen ist.

Das in Fig. 2 schematisch dargestellte Verfahren ist zur Bestimmung der Resonanzfrequenz 4 des Quantensystems 6 in dem Frequenzbereich 8 vorgesehen, sowie dafür geeignet und eingerichtet. Die nachfolgenden Ausführungen beziehen sich hierbei auf einen Frequenzbereich 8, in welchem lediglich eine Resonanzfrequenz 4 enthalten ist. Das Verfahren ist jedoch sinngemäß auch für Frequenzbereiche 8 mit mehreren Resonanzfrequenzen 4 anwendbar.

Das Verfahren wird in einem Verfahrensbeginn 32 gestartet. In einem ersten Verfahrensschritt 34 wird der Frequenzbereich 8 in eine Anzahl von gleich großen Frequenzbins 36 unterteilt. Der Verfahrensschritt 34 ist in der Fig. 3 schematisch veranschaulicht. Das Diagramm der Fig. 3 weist hierbei zwei horizontale, übereinander angeordnete Abschnitte 38, 40 auf. Horizontal, das bedeutet entlang einer X- oder Abszissenachse erstreckt sich der zu untersuchende Frequenzbereich 8. Der Abschnitt 38 zeigt hierbei die Unterteilung des Frequenzbereichs 8 in Frequenzbins 36. In dem dargestellten Ausführungsbeispiel ist der Frequenzbereich 8 beispielhaft in acht Frequenzbins 36a bis 36h unterteilt. Der Abschnitt 40 zeigt ein (Resonanz-)Spektrum des Quantensystems 6, wobei sich die durch einen Peak dargestellte Resonanzfrequenz 4 innerhalb des Frequenzbins 36g befindet.

Die Unterteilung, Gruppierung oder Reihenfolge der Frequenzbins 36 erfolgt beispielsweise linear, oder vorzugsweise in einem Pseudo-Random-Verfahren. Dies bedeutet, dass die Frequenzbins 36 beispielsweise in einer zufälligen Reihenfolge in einem zweiten Verfahrensschritt 42 verwendet werden.

Der Verfahrensschritt 42 wird beispielsweise für jedes Frequenzbin 36a... 36g einzeln durchgeführt. Hierbei wird zunächst für das jeweilige Frequenzbin 36a... 36g in einem Verfahrensschritt 44 eine Messfrequenz 14 erzeugt, welche in einem Verfahrensschritt 46 signalverarbeitungstechnisch zu einer das Frequenzbin 36 abdeckenden Frequenzgruppe 18 aufgeweitet wird. Die Verfahrensschritte 44 und 46 sind in der Fig. 4 schematisch veranschaulicht.

In dem Verfahrensschritt 44 erzeugt der Signalgenerator 10 ein Anregungssignal 12 mit einer schmalen, beispielsweise etwa deltaförmigen, Messfrequenz 14. Das Anregungssignal 12 ist insbesondere ein Anregungspuls mit einer endlichen Pulsdauer, so dass die Messfrequenz 14 zumindest eine gewisse Frequenzbreite aufweist. Die Messfrequenz 14 weist hierbei einen Frequenzwert auf, welcher innerhalb des jeweiligen Frequenzbins 36 liegt. Insbesondere ist die Messfrequenz 14 beispielsweise um einen Frequenzwert in der Mitte des jeweiligen Frequenzbins 36 zentriert. In dem Verfahrensschritt 46 wird das Anregungssignal 12 beziehungsweise die Messfrequenz 14 mittels der Aufweitungseinheit 16 zu der Frequenzgruppe 18 aufgeweitet oder gespreizt. Die Aufweitungseinheit 16 verwendet hierbei ein Frequenz-Spreiz-Verfahren, beispielsweise ein Frequency-Hopping-Spread-Spectrum-Verfahren. Die Bandbreite des dadurch gebildeten Anregungssignal 12' deckt hierbei im Wesentlichen die komplette (Frequenz-)Breite des jeweiligen Frequenzbins 36 ab.

Das Anregungssignal 12' wird dem Kontrollsystem 20 zugeführt, welches das Anregungssignal 12' in die korrespondierende Strahlung 22 wandelt, und somit in einem Verfahrensschritt 48 das Quantensystem 6 manipuliert. Durch die Frequenzgruppe 18 wird das Quantensystem 6 gleichzeitig mit einer Anzahl von unterschiedlichen Frequenzen angeregt, wobei die Messeinheit 28 hierbei das Messsignal 26 als Reaktion des Quantensystems 6 erfasst. Ist ein Arbeitspunkt, also eine Resonanzfrequenz 4, in der aktuellen Frequenzgruppe 16 beziehungsweise in dem Frequenzbin 36 enthalten, so ändert sich das Messsignal 26.

In einem Schwellwertvergleich 50 wird das Messsignal 26 daher mit einem hinterlegten Schwellwert verglichen. Der Schwellwert ist hierbei hinsichtlich einer zu erwartenden Messsignaländerung im Resonanzfall dimensioniert.

In einem dritten Verfahrensschritt 52 wird die Resonanzfrequenz 4 anhand derjenigen Messignale 26 bestimmt, welche den Schwellwert erreicht oder überschritten haben. Die Messsignale 26, bei welchem der Schwellwert erreicht oder überschritten wird, entsprechen hierbei einer Kandidaten-Frequenzgruppe oder Kandidaten für Frequenzbins, in welchen sich die gesuchte Resonanzfrequenz 4 befindet. Um die Resonanzfrequenz 4 mit höherer Genauigkeit zu bestimmen, kann in den resultierenden Kandidaten-Frequenzbins 36 nun wieder die relevanten Frequenzen gefunden werden. Dies kann durch iterative Anwendung des Verfahrens innerhalb der Kandidaten erfolgen. Hierbei werden in dem Verfahrensschritt 52 beispielsweise die Verfahrensschritte 34 und 42 iterativ wiederholt, wobei als neuer Frequenzbereich die jeweils vorangegangenen Kandidaten-Frequenzbins 36 verwendet werden. Die Breite der Frequenzbins 36 wird hierbei mit jeder Iteration angepasst, um breiter und somit schneller zu suchen, oder um schmaler und genauer die Arbeitspunkte zu finden. In dem gezeigte Ausführungsbeispiel der Fig. 3 wird zum Beispiel das Frequenzbin 36g in eine Anzahl von kleineren Frequenzbins 36 unterteilt, um die spektrale Position der Resonanzfrequenz 4 genauer zu bestimmen.

In einer möglichen Ausführungsform werden während des dritten Verfahrensschritts die vorangegangenen Messsignale 26 gewichtet aufaddiert. Mit anderen Worten werden alle zuvor erhaltenen Messungen am Ende gewichtet aufaddiert, und tragen somit zu einem besseren Signal-zu-Rausch-Verhältnis der Gesamtlösung bei. Die Suche kann auch vorzeitig abgebrochen und adaptiv auf bereits identifizierte Kandidaten verfeinert werden, zum Beispiel wenn eine vorgegebene oder vorgebbare Anzahl von Messsignalen 26, welche den Schwellwert erreicht oder überschritten haben, vorliegt. Insgesamt beschleunigt dies die Suche innerhalb eines gegebenen Frequenzbereichs 8, und verringert insbesondere die Verzögerung der Einsatzbereitschaft des Systems.

Nachdem mindestens eine Resonanzfrequenz 4 in dem Frequenzbereich 8 bestimmt wurde, wird das Verfahren mit einem Verfahrensende 54 beendet.

Das Verfahren findet somit iterativ die korrekten Resonanzfrequenzen. Zusammenfassend benötigt das Verfahren weniger Messzeit pro Messpunkt und präselektiert hierbei Kandidatenfrequenzen, wobei es so zügig und schrittweise von einem Frequenzscan der Arbeitspunktbestimmung in einen Festfrequenzbetrieb zur Kontrolle des Quantensystems übergeht.

Die beanspruchte Erfindung ist nicht auf die vorstehend beschriebenen Ausführungsbeispiele beschränkt. Vielmehr können auch andere Varianten der Erfindung von dem Fachmann hieraus im Rahmen der offenbarten Ansprüche abgeleitet werden, ohne den Gegenstand der beanspruchten Erfindung zu verlassen. Insbesondere sind ferner alle im Zusammenhang mit den verschiedenen Ausführungsbeispielen beschriebenen Einzelmerkmale im Rahmen der offenbarten Ansprüche auch auf andere Weise kombinierbar, ohne den Gegenstand der beanspruchten Erfindung zu verlassen.

So ist es beispielsweise möglich, ein auf Modulationstechniken basierendes Frequenz-Spreiz-Verfahren zur Erzeugung der Frequenzgruppen 18 zu verwenden, dessen Modulation zeitlich variiert. Diese bekannte Modulation wird vorzugsweise mit dem erfassten Messsignal 26 korreliert, wodurch die Arbeitsbedingung beziehungsweise Resonanzfrequenz 4 genauer bestimmt werden kann.

### Bezugszeichenliste

- 2: Vorrichtung
- 4: Resonanzfrequenz
- 6: Quantensystem
- 8: Frequenzbereich
- 10: Signalgenerator
- 12, 12': Anregungssignal
- 14: Messfrequenz
- 16: Aufweitungseinheit
- 18: Frequenzgruppe
- 20: Kontrollsystem
- 22: Strahlung
- 24: Quantenzustand
- 26: Messsignal
- 28: Messeinheit
- 30: Controller
- 32: Verfahrensbeginn
- 34: Verfahrensschritt
- 36, 36a... 36h: Frequenzbin
- 38, 40: Abschnitt
- 42, 44, 46, 48: Verfahrensschritt
- 50: Schwellwertvergleich
- 52: Verfahrensschritt
- 54: Verfahrensende

## Patentansprüche

1. Verfahren zur Bestimmung einer Resonanzfrequenz (4) eines Quantensystems (6) in einem Frequenzbereich (8),
- wobei in einem ersten Verfahrensschritt (34) der Frequenzbereich (8) in eine Anzahl von Frequenzbins (36, 36a... 36h) unterteilt wird,
- wobei in einem zweiten Verfahrensschritt (42) für jedes Frequenzbin (36, 36a...36h):
a) eine Messfrequenz (14) erzeugt wird,
b) die Messfrequenz (14) signalverarbeitungstechnisch zu einer das Frequenzbin (36, 36a...36h) abdeckenden Frequenzgruppe (18) aufgeweitet wird,
c) das Quantensystem (6) mit der Frequenzgruppe (18) manipuliert, und dabei ein resultierendes Messsignal (26) erfasst wird, und
d) das Messsignal (26) mit einem hinterlegten Schwellwert verglichen wird,
- wobei in einem dritten Verfahrensschritt (52) eine Resonanzfrequenz (4) anhand derjenigen Messignale (26) bestimmt wird, welche den Schwellwert erreicht oder überschritten haben,
- wobei in dem dritten Verfahrensschritt (52) die ersten und zweiten Verfahrensschritte (34, 42) iterativ wiederholt werden, wobei als Frequenzbereich (8) jeweils die jeweils vorangegangenen Frequenzbins (36, 36a... 36h) verwendet werden, bei welchen die Messsignale (26) den Schwellwert erreicht oder überschritten haben, **dadurch gekennzeichnet, dass** während des dritten Verfahrensschritts (52) die vorangegangenen Messsignale (26) gewichtet aufaddiert werden.

2. Verfahren nach Anspruch 1,
**dadurch gekennzeichnet,**
**dass** die Breite der Frequenzbins (36, 36a... 36h) mit jeder Iteration angepasst wird.

3. Verfahren nach Anspruch 1 oder 2,
**dadurch gekennzeichnet,**
**dass** die Unterteilung des Frequenzbereichs (8) in die Frequenzbins (36, 36a... 36h) anhand eines Pseudo-Random-Verfahrens erfolgt.

4. Verfahren nach einem der Ansprüche 1 bis 3,
**dadurch gekennzeichnet,**
**dass** die Messfrequenzen (14) durch ein Frequenz-Spreiz-Verfahren in die Frequenzgruppen (18) aufgeweitet werden.

5. Verfahren nach Anspruch 4,
**dadurch gekennzeichnet,**
**dass** das Frequenz-Spreiz-Verfahren moduliert ist, wobei die Modulation mit den Messsignalen (26) korreliert wird.

6. Verfahren nach einem der Ansprüche 1 bis 5,
**dadurch gekennzeichnet,**
**dass** das Quantensystem (6) ein Stickstofffehlstellen-Zentrum in einem Diamanten ist.

7. Vorrichtung (2) zur Bestimmung einer Resonanzfrequenz (4) eines Quantensystems (6) in einem Frequenzbereich (8), aufweisend
- einen Signalgenerator (10) zur Erzeugung einer Messfrequenz (14),
- eine Aufweitungseinheit (16) zur signalverarbeitungstechnischen Aufweitung der Messfrequenz (14) in eine Frequenzgruppe (18),
- ein Kontrollsystem (20) zur Manipulation des Quantensystems (6),
- eine Messeinheit (28) zur Erfassung eines Messsignals (26), und
- einen Controller (30), **dadurch gekennzeichnet, dass**
der Controller (30) zur Durchführung eines Verfahrens nach einem der Ansprüche 1 bis 6 eingerichtet ist.

8. Software auf einem Datenträger zur Durchführung eines Verfahrens nach einem der Ansprüche 1 bis 6, wenn die Software auf dem Controller der Vorrichtung nach Anspruch 7 abläuft.

## Claims

1. Method for determining a resonant frequency (4) of a quantum system (6) in a frequency range (8),
- wherein in a first method step (34) the frequency range (8) is divided into a number of frequency bins (36, 36a...36h),
- wherein in a second method step (42) for each frequency bin (36, 36a...36h) :
a) a measurement frequency (14) is generated,
b) the measurement frequency (14) is widened using signal processing to form a frequency group (18) covering the frequency bin (36, 36a...36h),
c) the quantum system (6) with the frequency group (18) is manipulated, and a resulting measurement signal (26) is captured, and
d) the measurement signal (26) is compared with a stored threshold value,
- wherein in a third method step (52) a resonant frequency (4) is determined on the basis of those measurement signals (26) which have reached or exceeded the threshold value,
- wherein in the third method step (52) the first and second method steps (34, 42) are iteratively repeated, wherein the respectively preceding frequency bins (36, 36a...36h), in which the measurement signals (26) have reached or exceeded the threshold value, are used as the frequency range (8) in each case, **characterized in that** during the third method step (52) the preceding measurement signals (26) are added up in a weighted manner.

2. Method according to Claim 1,
**characterized**
**in that** the width of the frequency bins (36, 36a...36h) is adjusted with each iteration.

3. Method according to Claim 1 or 2,
**characterized**
**in that** the frequency range (8) is divided into the frequency bins (36, 36a...36h) using a pseudo-random method.

4. Method according to one of Claims 1 to 3,
**characterized**
**in that** the measurement frequencies (14) are widened into the frequency groups (18) by means of a frequency spreading method.

5. Method according to Claim 4,
**characterized**
**in that** the frequency spreading method is modulated, wherein the modulation is correlated with the measurement signals (26).

6. Method according to one of Claims 1 to 5,
**characterized**
**in that** the quantum system (6) is a nitrogen vacancy centre in a diamond.

7. Device (2) for determining a resonant frequency (4) of a quantum system (6) in a frequency range (8), comprising
- a signal generator (10) for generating a measurement frequency (14),
- a widening unit (16) for widening the measurement frequency (14) into a frequency group (18) using signal processing,
- a control system (20) for manipulating the quantum system (6),
- a measuring unit (28) for capturing a measurement signal (26), and
- a controller (30), **characterized in that** the controller (30) is configured to carry out a method according to one of Claims 1 to 6.

8. Software on a data carrier for carrying out a method according to one of Claims 1 to 6 when the software runs on the controller of the device according to Claim 7

## Revendications

1. Procédé de détermination d'une fréquence de résonance (4) d'un système quantique (6) dans une plage de fréquences (8),
- dans une première étape de procédé (34), la plage de fréquences (8) étant subdivisée en un certain nombre de segments de fréquences (36, 36a...36h),
- dans une deuxième étape de procédé (42), pour chaque segment de fréquence (36, 36a...36h) :
a) une fréquence de mesure (14) étant générée,
b) la fréquence de mesure (14) étant élargies par technique de traitement du signal en un groupe de fréquences (18) couvrant le segment de fréquence (36, 36a...36h),
c) le système quantique (6) étant manipulé avec le groupe de fréquences (18), et un signal de mesure (26) résultant étant ici capturé, et
d) le signal de mesure (26) étant comparé à une valeur de seuil mémorisée,
- dans une troisième étape de procédé (52), une fréquence de résonance (4) étant déterminée à l'aide des signaux de mesure (26) qui ont atteint ou dépassé la valeur de seuil,
- dans la troisième étape de procédé (52), les première et deuxième étapes de procédé (34, 42) étant répétées de manière itérative, les segments de fréquence (36, 36a...36h) respectivement précédents, pour lesquels les signaux de mesure (26) ont atteint ou dépassé la valeur de seuil, étant respectivement utilisés comme plage de fréquence (8), **caractérisé en ce que** pendant la troisième étape de procédé (52), les signaux de mesure (26) précédents sont additionnés de manière pondérée.

2. Procédé selon la revendication 1,
**caractérisé en ce**
**que** la largeur des segments de fréquence (36, 36a...36h) est adaptée à chaque itération.

3. Procédé selon la revendication 1 ou 2,
**caractérisé en ce**
**que** la subdivision de la plage de fréquences (8) en segments de fréquences (36, 36a...36h) s'effectue à l'aide d'un procédé pseudo-aléatoire.

4. Procédé selon l'une des revendications 1 à 3,
**caractérisé en ce**
**que** les fréquences de mesure (14) sont élargies en les groupes de fréquences (18) par un procédé d'étalement de fréquence.

5. Procédé selon la revendication 4,
**caractérisé en ce**
**que** le procédé d'étalement de fréquence est modulé, la modulation étant corrélée avec les signaux de mesure (26).

6. Procédé selon l'une des revendications 1 à 5,
**caractérisé en ce**
**que** le système quantique (6) est un centre azote-lacune dans un diamant.

7. Dispositif (2) de détermination d'une fréquence de résonance (4) d'un système quantique (6) dans une plage de fréquences (8), comprenant
- un générateur de signaux (10) destiné à générer une fréquence de mesure (14),
- une unité d'élargissement (16) destinée à l'élargissement par traitement de signal de la fréquence de mesure (14) en un groupe de fréquences (18),
- un système de contrôle (20) destiné à la manipulation du système quantique (6),
- une unité de mesure (28) destinée à capturer un signal de mesure (26), et
- un contrôleur (30), **caractérisé en ce que** le contrôleur (30) est configuré pour mettre en œuvre un procédé selon l'une des revendications 1 à 6.

8. Logiciel sur un support de données pour la mise en œuvre d'un procédé selon l'une des revendications 1 à 6, lorsque le logiciel est exécuté sur le contrôleur du dispositif selon la revendication 7
